# EUROPEAN PATENT APPLICATION

(11) **EP 4 832 715 A1**
(43) Date of publication of application: **28.10.2026**
(21) Application number: 26163363.0
(22) Date of filing: 09.03.2026
(51) Int. Cl.: H10K 59/121, G09G 3/3233

(54) **DISPLAY DEVICE AND ELECTRONIC DEVICE**

(30) Priority: 21.04.2025 KR 20250051636
(71) Applicant: Samsung Display Co., Ltd., Yongin-si, Gyeonggi-do 17113 (KR)
(72) Inventor: KIM, Yeon Kyung, Yongin-si (KR); KIM, Kyung Bae, Yongin-si (KR); KIM, Dong Woo, Yongin-si (KR); LEE, Yong Hee, Yongin-si (KR)
(74) Representative: Marks & Clerk LLP

(57) **Abstract**

An electronic device includes a pixel including a light-emitting element between a driving voltage line and a common voltage line, a first transistor between the driving voltage line and the light-emitting element, and including a gate electrode connected to a first node and a source electrode connected to a second node, a second transistor including a source electrode connected to a data line and a drain electrode connected to the first node, and fourth and fifth transistors in series between the light-emitting element and an initialization voltage line, the fourth transistor being between a first electrode of the light-emitting element and the fifth transistor and including a gate electrode configured to receive a cascode voltage having a value between an active voltage of an initialization gate signal received by a gate electrode of the fifth transistor and a non-active voltage of the initialization gate signal.

## Description

### BACKGROUND

### 1. Field

The present disclosure relates to a display device and an electronic device capable of improving power consumption.

### 2. Description of the Related Art

The organic light-emitting diode display has self-light-emitting characteristics, and may have the reduced thickness and weight because of not requiring a separate light source, unlike the liquid crystal display. In addition, the organic light-emitting diode display is attracting attention as the next-generation display device for TVs, monitors, and portable electronic devices, because exhibiting high-quality characteristics, such as low power consumption, high luminance, and high response speed.

### SUMMARY

Aspects of the present disclosure provide a display device and an electronic device capable of improving power consumption.

According to an aspect of the present disclosure, there is provided a display device including a pixel including a light-emitting element connected between a driving voltage line and a common voltage line, a first transistor connected between the driving voltage line and the light-emitting element, and including a gate electrode connected to a first node and a source electrode connected to a second node, a second transistor including a gate electrode connected to a gate line, a source electrode connected to a data line, and a drain electrode connected to the first node, and a fourth transistor and a fifth transistor connected in series between the light-emitting element and an initialization voltage line, the fourth transistor being connected between a first electrode of the light-emitting element and the fifth transistor and including a gate electrode configured to receive a cascode voltage having a value between an active voltage of an initialization gate signal applied to a gate electrode of the fifth transistor and a non-active voltage of the initialization gate signal.

The fourth transistor and the fifth transistor may be a same type of transistor. The cascode voltage may be greater than the active voltage of the initialization gate signal and may be less than the non-active voltage of the initialization gate signal.

The fourth transistor and the fifth transistor may include p-type transistors.

The gate electrode of the fourth transistor may be connected to a cascode line configured to transmit the cascode voltage.

A source electrode of the fourth transistor may be connected to the first electrode of the light-emitting element and to a drain electrode of the first transistor. A drain electrode of the fourth transistor may be connected to a source electrode of the fifth transistor. A second electrode of the light-emitting element may be connected to the common voltage line.

The pixel may further include a capacitor connected between the first node and the second node.

The pixel may further include a third transistor connected between the driving voltage line and the second node.

In a first period, the gate electrode of the fifth transistor may be configured to receive the initialization gate signal having the active voltage, the gate electrode of the second transistor may be configured to receive a write gate signal having an active voltage, a gate electrode of the third transistor may be configured to receive an emission control signal having an active voltage, and the data line may be configured to receive a reference voltage.

In a second period after the first period, the initialization gate signal may be configured to have the active voltage, the write gate signal may be configured to have the active voltage, the emission control signal may be configured to have a non-active voltage, and the data line may be configured to receive the reference voltage in a first sub-period of the second period, and to receive a data voltage corresponding to the pixel in a second sub-period of the second period.

In a third period after the second period, the initialization gate signal may be configured to have the active voltage, the emission control signal may be configured to have the non-active voltage, and the write gate signal may be configured to have a non-active voltage.

In a fourth period after the third period, the emission control signal may be configured to have the active voltage, the initialization gate signal may be configured to have the non-active voltage, and the write gate signal may be configured to have the non-active voltage.

The first transistor, the second transistor, the third transistor, the fourth transistor, and the fifth transistor may include metal-oxide-semiconductor field-effect transistors (MOSFET).

According to another aspect of the present disclosure, there is provided an electronic device including a display device including a pixel, the pixel including a light-emitting element connected between a driving voltage line and a common voltage line, a first transistor connected between the driving voltage line and the light-emitting element, and including a gate electrode connected to a first node and a source electrode connected to a second node, a second transistor including a gate electrode connected to a gate line, a source electrode connected to a data line, and a drain electrode connected to the first node, and a fourth transistor and a fifth transistor connected in series between the light-emitting element and an initialization voltage line, the fourth transistor being connected between a first electrode of the light-emitting element and the fifth transistor, and including a gate electrode configured to receive a cascode voltage having a value between an active voltage of an initialization gate signal configured to be received by a gate electrode of the fifth transistor and a non-active voltage of the initialization gate signal.

The fourth transistor and the fifth transistor may include a same type of transistor. The cascode voltage may be greater than the active voltage of the initialization gate signal and may be less than the non-active voltage of the initialization gate signal.

The fourth transistor and the fifth transistor may include p-type transistors.

The gate electrode of the fourth transistor may be connected to a cascode line configured to transmit the cascode voltage.

A source electrode of the fourth transistor may be connected to the first electrode of the light-emitting element and to a drain electrode of the first transistor. A drain electrode of the fourth transistor may be connected to a source electrode of the fifth transistor. A second electrode of the light-emitting element may be connected to the common voltage line.

The pixel may further include a capacitor connected between the first node and the second node.

The pixel may further include a third transistor connected between the driving voltage line and the second node.

The electronic device may include a smartphone, a tablet, a laptop, a TV, a desk monitor, a smart glasses, a smart watch, a head-mounted display, or a vehicle.

According to the display device and the electronic device according to one or more embodiments, the power consumption may be improved.

For example, the pixel according to one or more embodiments includes a fourth transistor and a fifth transistor connected in series between the light-emitting element and the initialization voltage line, and in this case, the fourth transistor, which receives the cascode voltage through the gate electrode, may act as a resistor. Accordingly, the voltage between the anode electrode of the light-emitting element and the initialization voltage line may be divided. Therefore, at least one of the fourth transistor and the fifth transistor may be used as a low-voltage region transistor capable of operating in a low-voltage region. Therefore, the power consumption of the display device may be improved.

The aspects of the present disclosure are not limited to the above-described aspects, and other aspects that are not described herein will become apparent to those skilled in the art from the following description.

At least some of the above and other features of the invention are set out in the claims.

### BRIEF DESCRIPTION OF THE DRAWINGS

The above and other aspects of the present disclosure will become more apparent by describing in detail embodiments thereof with reference to the attached drawings, in which:
FIG. 1 is an exploded perspective view illustrating a display device according to one or more embodiments;
FIG. 2 is a block diagram illustrating the display device according to one or more embodiments;
FIG. 3 is an equivalent circuit diagram of a pixel according to one or more embodiments;
FIG. 4 is a timing diagram of an emission control signal, an initialization gate signal, a write gate signal, a cascode voltage, and a data voltage of FIG. 3;
FIG. 5 is a diagram for describing an operation of the display device of FIG. 3 in a first period of FIG. 4;
FIG. 6 is a diagram for describing an operation of the display device of FIG. 3 in a second period of FIG. 4;
FIG. 7 is a diagram for describing an operation of the display device of FIG. 3 in a third period of FIG. 4;
FIG. 8 is a diagram for describing an operation of the display device of FIG. 3 in a fourth period of FIG. 4;
FIG. 9 is a block diagram of an electronic device according to one or more embodiments; and
FIGS. 10, 11, and 12 are schematic diagrams of electronic devices according to various embodiments.

### DETAILED DESCRIPTION

Aspects of some embodiments of the present disclosure and methods of accomplishing the same may be understood more readily by reference to the detailed description of embodiments and the accompanying drawings. The described embodiments are provided as examples so that this disclosure will be thorough and complete, and will fully convey the aspects of the present disclosure to those skilled in the art. Accordingly, processes, elements, and techniques that are redundant, that are unrelated or irrelevant to the description of the embodiments, or that are not necessary to those having ordinary skill in the art for a complete understanding of the aspects of the present disclosure may be omitted. Unless otherwise noted, like reference numerals, characters, or combinations thereof denote like elements throughout the attached drawings and the written description, and thus, repeated descriptions thereof may be omitted.

The described embodiments may have various modifications and may be embodied in different forms, and should not be construed as being limited to only the illustrated embodiments herein. The use of "can," "may," or "may not" in describing an embodiment corresponds to one or more embodiments of the present disclosure.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

In the drawings, the relative sizes of elements, layers, and regions may be exaggerated for clarity and/or descriptive purposes. In other words, because the sizes and thicknesses of elements in the drawings are arbitrarily illustrated for convenience of description, the disclosure is not limited thereto. As such, variations from the shapes of the illustrations as a result of, for example, manufacturing techniques and/or tolerances, are to be expected. Further, specific structural or functional descriptions disclosed herein are merely illustrative for the purpose of describing embodiments according to the concept of the present disclosure. Thus, embodiments disclosed herein should not be construed as limited to the illustrated shapes of elements, layers, or regions, but are to include deviations in shapes that result from, for instance, manufacturing.

Further, the phrase "in a plan view" means when an object portion is viewed from above. The terms "overlap" or "overlapped" mean that a first object may be above or below or to a side of a second object, and vice versa. Additionally, the term "overlap" may include stack, face or facing, extending over, covering, or partly covering or any other suitable term as would be appreciated and understood by those of ordinary skill in the art. The expression "not overlap" may include meaning, such as "apart from" or "set aside from" or "offset from" and any other suitable equivalents as would be appreciated and understood by those of ordinary skill in the art. The terms "face" and "facing" may mean that a first object may directly or indirectly oppose a second object. In a case in which a third object intervenes between a first and second object, the first and second objects may be understood as being indirectly opposed to one another, although still facing each other.

It will be understood that when an element, layer, region, or component (e.g., an apparatus, a device, a circuit, a wire, an electrode, a terminal, a conductive film, etc.) is referred to as being "formed on," "on," "connected to," or "(operatively, functionally, or communicatively) coupled to" another element, layer, region, or component, it can be directly formed on, on, connected to, or coupled to the other element, layer, region, or component, or indirectly formed on, on, connected to, or coupled to the other element, layer, region, or component such that one or more intervening elements, layers, regions, or components may be present. In addition, this may collectively mean a direct or indirect coupling or connection and an integral or non-integral coupling or connection.

For example, when a layer, region, or component is referred to as being "electrically connected" or "electrically coupled" to another layer, region, or component, it can be directly electrically connected or coupled to the other layer, region, and/or component or one or more intervening layers, regions, or components may be present. The one or more intervening components may include a switch, a transistor, a resistor, an inductor, a capacitor, a diode and/or the like. Accordingly, a connection is not limited to the connections illustrated in the drawings or the detailed description and may also include other types of connections. In describing embodiments, an expression of connection indicates electrical connection unless explicitly described to be direct connection, and "directly connected/directly coupled," or "directly on," refers to one component directly connecting or coupling another component, or being on another component, without an intermediate component.

Meanwhile, other expressions describing relationships between components, such as "between," "immediately between" or "adjacent to" and "directly adjacent to," may be construed similarly. It will be understood that when an element or layer is referred to as being "between" two elements or layers, it can be the only element or layer between the two elements or layers, or one or more intervening elements or layers may also be present.

For the purposes of this disclosure, expressions such as "at least one of," or "any one of," or "one or more of" when preceding a list of elements, modify the entire list of elements and do not modify the individual elements of the list. For example, "at least one of X, Y, and Z," "at least one of X, Y, or Z," "at least one selected from the group consisting of X, Y, and Z," and "at least one selected from the group consisting of X, Y, or Z" may be construed as X only, Y only, Z only, any combination of two or more of X, Y, and Z, such as, for instance, XYZ, XY, YZ, and XZ, or any variation thereof. Similarly, the expressions "at least one of A and B" and "at least one of A or B" may include A, B, or A and B. As used herein, "or" generally means "and/or," and the term "and/or" includes any and all combinations of one or more of the associated listed items. For example, the expression "A and/or B" may include A, B, or A and B. Similarly, expressions such as "at least one of," "a plurality of," "one of," and other prepositional phrases, when preceding a list of elements, modify the entire list of elements and do not modify the individual elements of the list. When "C to D" is stated, it means C or more and D or less, unless otherwise specified.

It will be understood that, although the terms "first," "second," "third," etc., may be used herein to describe various elements, components, regions, layers and/or sections, these elements, components, regions, layers and/or sections should not be limited by these terms. These terms do not correspond to a particular order, position, or superiority, and are only used to distinguish one element, member, component, region, area, layer, section, or portion from another element, member, component, region, area, layer, section, or portion. Thus, a first element, component, region, layer, or section described below could be termed a second element, component, region, layer, or section, without departing from the scope of the present disclosure. The description of an element as a "first" element may not require or imply the presence of a second element or other elements. The terms "first," "second," etc. may also be used herein to differentiate different categories or sets of elements. For conciseness, the terms "first," "second," etc. may represent "first-category (or first-set)," "second-category (or second-set)," etc., respectively.

In the examples, the x-axis, the y-axis, and/or the z-axis are not limited to three axes of a rectangular coordinate system, and may be interpreted in a broader sense. For example, the x-axis, the y-axis, and the z-axis may be perpendicular to one another, or may represent different directions that are not perpendicular to one another. The same applies for first, second, and/or third directions.

The terminology used herein is for the purpose of describing embodiments only and is not intended to be limiting of the present disclosure. As used herein, the singular forms "a" and "an" are intended to include the plural forms as well, while the plural forms are also intended to include the singular forms, unless the context clearly indicates otherwise. It will be further understood that the terms "comprises," "comprising," "have," "having," "includes," and "including," when used in this specification, specify the presence of the stated features, integers, steps, operations, elements, and/or components, but do not preclude the presence or addition of one or more other features, integers, steps, operations, elements, components, and/or groups thereof.

As used herein, the terms "substantially," "about," "approximately," and similar terms are used as terms of approximation and not as terms of degree, and are intended to account for the inherent deviations in measured or calculated values that would be recognized by those of ordinary skill in the art. For example, "substantially" may include a range of +/- 5 % of a corresponding value. "About" or "approximately," as used herein, is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value. Further, the use of "may" when describing embodiments of the present disclosure refers to "one or more embodiments of the present disclosure." Furthermore, the expression "being the same" may mean "being substantially the same." In other words, the expression "being the same" may include a range that can be tolerated by those of ordinary skill in the art. The other expressions may also be expressions from which "substantially" has been omitted.

In some embodiments well-known structures and devices may be described in the accompanying drawings in relation to one or more functional blocks (e.g., block diagrams), units, and/or modules to avoid unnecessarily obscuring various embodiments. Those skilled in the art will understand that such block, unit, and/or module are/is physically implemented by a logic circuit, an individual component, a microprocessor, a hard wire circuit, a memory element, a line connection, and other electronic circuits. This may be formed using a semiconductor-based manufacturing technique or other manufacturing techniques. The block, unit, and/or module implemented by a microprocessor or other similar hardware may be programmed and controlled using software to perform various functions discussed herein, optionally may be driven by firmware and/or software. In addition, each block, unit, and/or module may be implemented by dedicated hardware, or a combination of dedicated hardware that performs some functions and a processor (for example, one or more programmed microprocessors and related circuits) that performs a function different from those of the dedicated hardware. In addition, in some embodiments, the block, unit, and/or module may be physically separated into two or more interact individual blocks, units, and/or modules without departing from the scope of the present disclosure. In addition, in some embodiments, the block, unit and/or module may be physically combined into more complex blocks, units, and/or modules without departing from the scope of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

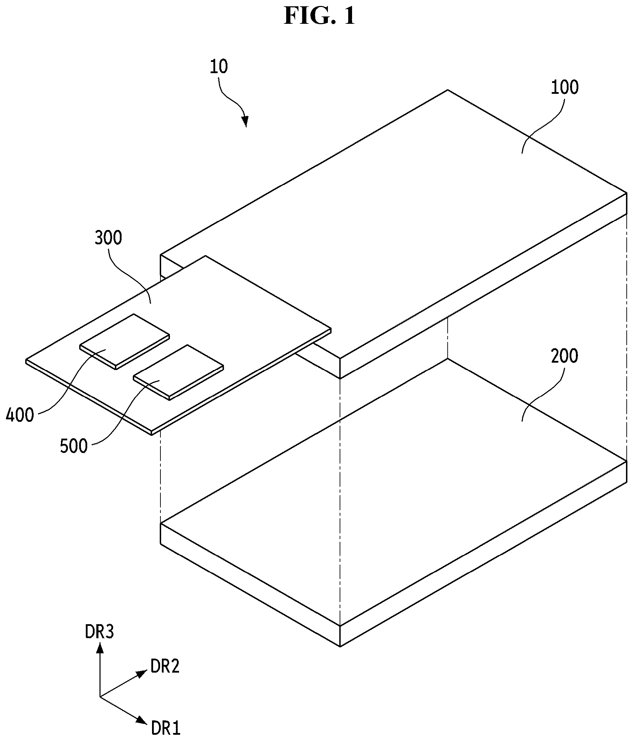

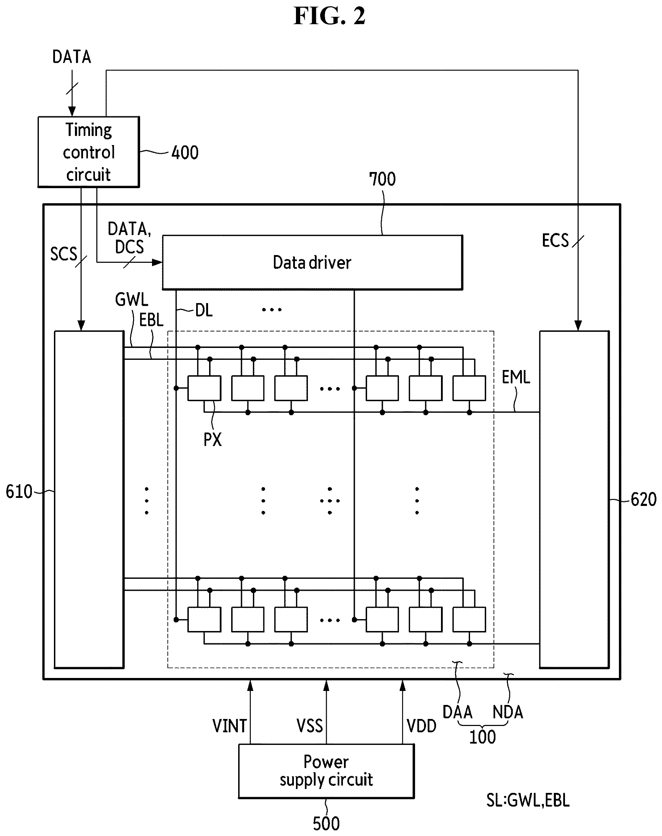

FIG. 1 is an exploded perspective view illustrating a display device according to one or more embodiments. FIG. 2 is a block diagram illustrating the display device according to one or more embodiments.

Referring to FIGS. 1 and 2, a display device 10 according to one or more embodiments is a device displaying a moving image or a still image. The display device 10 according to one or more embodiments may be applied to portable electronic devices, such as a mobile phone, a smart phone, a tablet personal computer (PC), a mobile communication terminal, an electronic notebook, an electronic book, a portable multimedia player (PMP), navigation, or an ultra-mobile PC (UMPC). For example, the display device 10 according to one or more embodiments may be applied to a display unit of a television, a laptop computer, a monitor, a billboard, or the Internet of Things (IoT). Alternatively, the display device 10 according to one or more embodiments may be applied to a smart watch, a watch phone, or a head-mounted display (HMD) for implementing virtual reality and augmented reality.

The display device 10 according to one or more embodiments may include a display panel 100, a heat dissipation layer 200, a circuit board 300, a timing control circuit 400, and a power supply circuit 500.

The display panel 100 may be formed in a planar shape similar to a quadrangle. For example, the display panel 100 may have a planar shape similar to a quadrangle having short sides in a first direction DR1, and long sides in a second direction DR2 crossing the first direction DR1. In the display panel 100, a corner where the short side in the first direction DR1 and the long side in the second direction DR2 meet may be rounded to have a curvature or may be formed at a right angle. The planar shape of the display panel 100 is not limited to the quadrangle, and may be formed similarly to other polygons, circles, or ovals. A planar shape of the display device 10 may follow the planar shape of the display panel 100, but the present disclosure is not limited thereto.

The display panel 100 may include a plurality of pixels PX, a plurality of gate lines SL, an emission control line EML, a plurality of data lines DL, a gate driver 610, a light-emitting driver 620, and a data driver 700. The display panel 100 may be divided into a display area DAA displaying an image and a non-display area NDA that does not display an image, as illustrated in FIG. 2.

The plurality of pixels PX may be located in the display area DAA. The plurality of pixels PX may be arranged in a matrix form in the first direction DR1 and in the second direction DR2. The plurality of gate lines SL and the emission control lines EML may extend in the first direction DR1 and may be located in the second direction DR2. The plurality of data lines DL may extend in the second direction DR2 and may be located in the first direction DR1. Here, a plurality of pixels PX that are located adjacent to each other and provide light of different colors (e.g., three adjacent pixels PX) may form one unit pixel.

Each of the plurality of pixels PX may include a plurality of transistors (e.g., pixel transistors). The plurality of pixel transistors may be formed through a semiconductor process and may be formed on a semiconductor substrate (e.g., a wafer). For example, each of the plurality of pixel transistors may be a metal-oxide-semiconductor field-effect transistor (MOSFET).

The plurality of gate lines SL may include a plurality of write gate lines GWL and a plurality of initialization gate lines EBL.

Each of the plurality of pixels PX may be connected to any one write gate line GWL of the plurality of write gate lines GWL, any one initialization gate line GIL of the plurality of initialization gate lines GIL, any one emission control line EML of the plurality of emission control lines EML, and any one data line DL of the plurality of data lines DL. Each of the plurality of pixels PX may receive a data voltage of the data line DL according to a write gate signal of the write gate line GWL, and may emit light from a light-emitting element according to the data voltage.

The gate driver 610, the light-emitting driver 620, and the data driver 700 may be located in the non-display area NDA.

The gate driver 610 may include a plurality of gate transistors, and the light-emitting driver 620 may include a plurality of light-emitting transistors. The plurality of gate transistors and the plurality of light-emitting transistors may be formed through a semiconductor process and may be formed on a semiconductor substrate. For example, each of the plurality of gate transistors and the plurality of light-emitting transistors may be a MOSFET.

The gate driver 610 may generate write gate signals according to a gate-timing control signal SCS of the timing control circuit 400, and may sequentially output the write gate signals to the write gate lines GWL. In addition, the gate driver 610 may generate initialization gate signals according to the gate-timing control signal SCS, and may sequentially output the initialization gate signals to the initialization gate lines EBL.

The light-emitting driver 620 may generate emission control signals according to an emission-timing control signal ECS, and may sequentially output the emission control signals to the emission control lines EML.

The data driver 700 may include a plurality of data transistors, and the plurality of data transistors may be formed through a semiconductor process and may be formed on a semiconductor substrate. For example, each of the plurality of data transistors may be a MOSFET.

The data driver 700 may receive digital video data DATA and a data-timing control signal DCS from the timing control circuit 400. The data driver 700 may convert the digital video data DATA into analog data voltages according to the data-timing control signal DCS, and may output the converted analog data voltages to the data lines DL. In this case, pixels PX may be selected by the write gate signal of the gate driver 610, and the data voltages may be supplied to the selected pixels PX.

The heat dissipation layer 200 may overlap the display panel 100 in a third direction DR3, which is a thickness direction of the display panel 100. The heat dissipation layer 200 may be located on one surface of the display panel 100, for example, a rear surface of the display panel 100. The heat dissipation layer 200 may serve to dissipate heat generated from the display panel 100. The heat dissipation layer 200 may include a metal layer, such as graphite, silver (Ag), copper (Cu), or aluminum (Al) having high thermal conductivity.

The circuit board 300 may be electrically connected to a plurality of pads of a pad portion of the display panel 100 by using a conductive adhesive member, such as an anisotropic conductive film. The circuit board 300 may be a flexible printed circuit board or flexible film made of a flexible material. It is illustrated in FIG. 1 that the circuit board 300 is unfolded, but the circuit board 300 may be bent. In this case, one end of the circuit board 300 may be located on the rear surface of the display panel 100 and/or a rear surface of the heat dissipation layer 200. The other end of the circuit board 300 may be connected to the plurality of pads of the pad portion of the display panel 100 by using a conductive adhesive member. One end of the circuit board 300 may be an end opposite to the other end of the circuit board 300.

The timing control circuit 400 may receive digital video data and timing signals from the outside. The timing control circuit 400 may generate a gate-timing control signal SCS, an emission-timing control signal ECS, and a data-timing control signal DCS for controlling the display panel 100 according to the timing signals. The timing control circuit 400 may output the gate-timing control signal SCS to the gate driver 610, and may output the emission-timing control signal ECS to the light-emitting driver 620. The timing control circuit 400 may output the digital video data and the data-timing control signal DCS to the data driver 700.

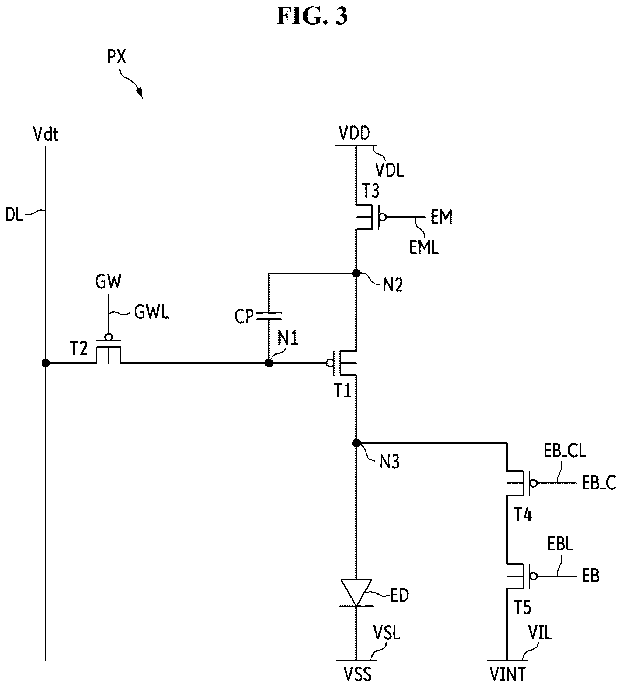

The power supply circuit 500 may generate a plurality of panel driving voltages according to a power voltage from the outside. For example, the power supply circuit 500 may generate a driving voltage VDD, a common voltage VSS, and an initialization voltage VINT, and may supply the driving voltage VDD, the common voltage VSS, and the initialization voltage VINT to the display panel 100. A description of the driving voltage VDD, the common voltage VSS, and the initialization voltage VINT will be described later with reference to FIG. 3.

Each of the timing control circuit 400 and the power supply circuit 500 may be formed as an integrated circuit (IC) and attached to one surface of the circuit board 300. In this case, the gate-timing control signal SCS, the emission-timing control signal ECS, the digital video data DATA, and the data-timing control signal DCS of the timing control circuit 400 may be supplied to the display panel 100 through the circuit board 300. In addition, the common voltage VSS, the driving voltage VDD, and the initialization voltage VINT of the power supply circuit 500 may be supplied to the display panel 100 through the circuit board 300.

Alternatively, each of the timing control circuit 400 and the power supply circuit 500 may be located in the non-display area NDA of the display panel 100, similarly to the gate driver 610, the light-emitting driver 620, and the data driver 700. In this case, the timing control circuit 400 may include a plurality of timing transistors, and each power supply circuit 500 may include a plurality of power transistors. The plurality of timing transistors and the plurality of power transistors may be formed through a semiconductor process and may be formed on a semiconductor substrate. For example, each of the plurality of timing transistors and the plurality of power transistors may be a MOSFET. Each of the timing control circuit 400 and the power supply circuit 500 may be located between the data driver 700 and the pad portion.

FIG. 3 is an equivalent circuit diagram of a pixel according to one or more embodiments.

Referring to FIG. 3, the pixel PX may be connected to the write gate line GWL, the initialization gate line EBL, the emission control line EML, and the data line DL. In addition, the pixel PX may be connected to the driving voltage line VDL to which the driving voltage VDD is applied, the common voltage line VSL to which the common voltage VSS is applied, and the initialization voltage line VIL to which the initialization voltage VINT is applied.

The driving voltage VDD, the common voltage VSS, and the initialization voltage VINT may each be a DC voltage. The initialization voltage VINT may be greater than the common voltage VSS and less than the driving voltage VDD. For example, the driving voltage VDD may have a value of about 8.8 V, the common voltage VSS may have a value of about 0 V, and the initialization voltage VINT may have a value of about 1.5 V.

The pixel PX may include a plurality of transistors T1, T2, T3, T4, and T5, a light-emitting element ED, and a capacitor CP.

The light-emitting element ED emits light according to a driving current flowing through a channel of a first transistor T1. An amount of light emitted from the light-emitting element ED may be proportional to the driving current. The light-emitting element ED may be connected between the first transistor T1 and the common voltage line VSL. For example, a first electrode (e.g., an anode electrode) of the light-emitting element ED may be connected to a drain electrode of the first transistor T1 (e.g., a third node N3), and a second electrode (e.g., a cathode electrode) of the light-emitting element ED may be connected to the common voltage line VSL. The light-emitting element ED may be an organic light-emitting diode including a first electrode, a second electrode, and an organic light-emitting layer located between the electrodes (e.g., the first electrode and the second electrode), but the present disclosure is not limited thereto. For example, the light-emitting element ED may be an inorganic light-emitting element including a first electrode, a second electrode, and an inorganic semiconductor located between the electrodes (e.g., the first electrode and the second electrode). In this case, the light-emitting element ED may be a micro light-emitting diode.

The first transistor T1 may be a driving transistor that controls the amount (e.g., density) of drain-source flowing between a drain electrode and a source electrode according to a voltage applied to a gate electrode. The first transistor T1 may include a gate electrode connected to a first node N1, a source electrode connected to a second node N2, and a drain electrode connected to a source electrode of a fourth transistor T4. In addition, the first transistor T1 may further include a body electrode connected to the driving voltage line VDL.

Because a second transistor T2 may be controlled by the write gate signal GW, the second transistor T2 may be connected between the data line DL and the first node N1. The second transistor T2 may include a gate electrode connected to the write gate line GWL, a source electrode connected to the data line DL, and a drain electrode connected to the first node N1. In addition, the second transistor T2 may further include a body electrode connected to the driving voltage line VDL. The write gate line GWL may transmit the write gate signal GW.

Because a third transistor T3 may be controlled by the emission control signal EM, the third transistor T3 may be connected between the driving voltage line VDL and the second node N2. The third transistor T3 may include a gate electrode connected to the emission control line EML, a source electrode connected to the driving voltage line VDL, and a drain electrode connected to the second node N2. In addition, the third transistor T3 may further include a body electrode connected to the driving voltage line VDL. The emission control line EML may transmit the emission control signal EM.

A fourth transistor T4 may be controlled by a cascode voltage EB_C, and the fourth transistor T4 may be connected between the first electrode of the light-emitting element ED (e.g., a third node N3) and a source electrode of a fifth transistor T5. The fourth transistor T4 may include a gate electrode connected to a cascode line EB_CL, a source electrode connected to the first electrode of the light-emitting element ED (e.g., to the third node N3), and a drain electrode connected to the source electrode of the fifth transistor T5. In addition, the fourth transistor T4 may further include a body electrode connected to the driving voltage line VDL. The cascode line EB_CL may transmit the cascode voltage EB_C.

A fifth transistor T5 may be controlled by the initialization gate signal EB, and the fifth transistor T5 may be connected between the drain electrode of the fourth transistor T4 and the initialization voltage line VIL. The fifth transistor T5 may include a gate electrode connected to the initialization gate line EBL, a source electrode connected to the drain electrode of the fourth transistor T4, and a drain electrode connected to the initialization voltage line VIL. In addition, the fifth transistor T5 may further include a body electrode connected to the initialization voltage line VIL. The initialization gate line EBL may transmit the initialization gate signal EB, and the initialization voltage line VIL may transmit the initialization voltage VINT.

The first to fifth transistors T1, T2, T3, T4, and T5 described above may each be a metal-oxide-semiconductor field-effect transistor (MOSFET). For example, the first to fifth transistors T1, T2, T3, T4, and T5 may each be a p-type MOSFET.

The capacitor CP may be connected between the gate electrode of the first transistor T1 (e.g., the first node N1) and the source electrode of the first transistor T1 (e.g., the second node N2).

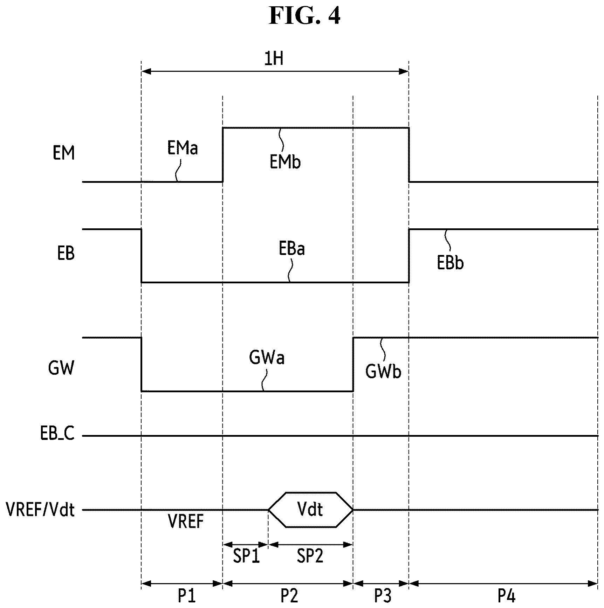

FIG. 4 is a timing diagram of an emission control signal EM, an initialization gate signal EB, a write gate signal GW, a cascode voltage EB_C, and a data voltage Vdt of FIG. 3.

Referring to FIG. 4, the display device 10 may operate based on a first period P1, a second period P2, a third period P3, and a fourth period P4.

The emission control signal EM, the initialization gate signal EB, and the write gate signal GW, which are each provided as pulse-type signals, may respectively have active voltages EMa, EBa, and GWa or non-active voltages EMb, EBb, and GWb respectively for each of the periods P1, P2, P3, and P4 described above. Here, the active voltages EMa, EBa, and GWa of each of the signals EM, EB, and GW described above may mean voltage levels that may turn on the corresponding transistors to which the corresponding signals are applied. In other words, the signal of the active voltage may have a value greater than a threshold voltage of the corresponding transistor. For example, when the corresponding transistor is a p-type transistor, the active voltage of the signal applied to the gate electrode of the corresponding transistor may mean a low level (e.g., a negative polarity level or a low voltage level).

The non-active level of each of the signals EM, EB, and GW may mean a voltage level that may turn off the corresponding transistor. In other words, the signal of the non-active level may have a value less than the threshold voltage of the corresponding transistor. For example, when the corresponding transistor is a p-type transistor, the non-active voltage of the signal applied to the gate electrode of the corresponding transistor may mean a high level (e.g., a positive polarity level or a high voltage level).

Contrastingly, when the corresponding transistor is an n-type transistor, the active voltage of each of the signals EM, EB, and GW applied to the gate electrode of the corresponding transistor may mean a high level (e.g., a positive polarity level or a high voltage level), and the non-active voltage of the signal applied to the gate electrode of the corresponding transistor may mean a low level (e.g., a negative polarity level or a low voltage level).

For example, as illustrated in FIG. 4, the emission control signal EM may have an active voltage EMa of a low level and a non-active voltage EMb of a high level, the initialization gate signal EB may have an active voltage EBa of a low level and a non-active voltage EBb of a high level, and the write gate signal GW may have an active voltage GWa of a low level and a non-active voltage GWb of a high level.

The active voltage EMa of the emission control signal EM, the active voltage EBa of the initialization gate signal EB, and the active voltage GWa of the write gate signal GW may be the same as each other. For example, the active voltage EMa of the emission control signal EM, the active voltage EBa of the initialization gate signal EB, and the active voltage GWa of the write gate signal GW may each have a voltage of about -0.8 V.

The non-active voltage EMb of the emission control signal EM, the non-active voltage EBb of the initialization gate signal EB, and the non-active voltage GWb of the write gate signal GW may be the same as each other. For example, the non-active voltage EMb of the emission control signal EM, the non-active voltage EBb of the initialization gate signal EB, and the non-active voltage GWb of the write gate signal GW may each have a voltage of about 4.7 V.

According to one or more embodiments, the pixel PX may include the fourth transistor T4 connected between the first electrode of the light-emitting element ED (e.g., the third node N3) and the source electrode of the fifth transistor T5. The pixel PX may include the fourth transistor T4 and the fifth transistor T5 connected in series between the first electrode of the light-emitting element ED and the initialization voltage line VIL. In this case, the cascode voltage EB_C applied to the fourth transistor T4 may be greater than a relatively smaller voltage among the active voltage and the non-active voltage of either signal, and may be less than a relatively greater voltage. According to one or more embodiments, the cascode voltage EB_C applied to the fourth transistor T4 may have a value between the active voltage EBa and the non-active voltage EBb of the gate signal (e.g., the initialization gate signal EB) applied to the gate electrode of another transistor (e.g., the fifth transistor T5) of the pixel PX. For example, the cascode voltage EB_C may be greater than the active voltage EBa of the gate signal (e.g., the initialization gate signal EB) applied to a transistor (e.g., the fifth transistor T5) of the same type (e.g., p-type) as the fourth transistor T4, and may be less than the non-active voltage EBb of the gate signal (e.g., the initialization gate signal EB). For example, the cascode voltage EB_C may be greater than about -0.8 V and less than about 4.7 V. As an example, the cascode voltage EB_C may be about 4 V. Therefore, resistance of the turned-on fourth transistor T4 may be greater than resistance of another turned-on transistor (e.g., the fifth transistor T5). The fourth transistor T4 may be kept always turned on by the cascode voltage EB_C. For example, the fourth transistor T4 may remain turned on during the first to fourth periods P1 to P4.

In FIG. 4, one horizontal period 1H may be defined as a period during which the initialization gate signal EB is maintained at the active voltage EBa.

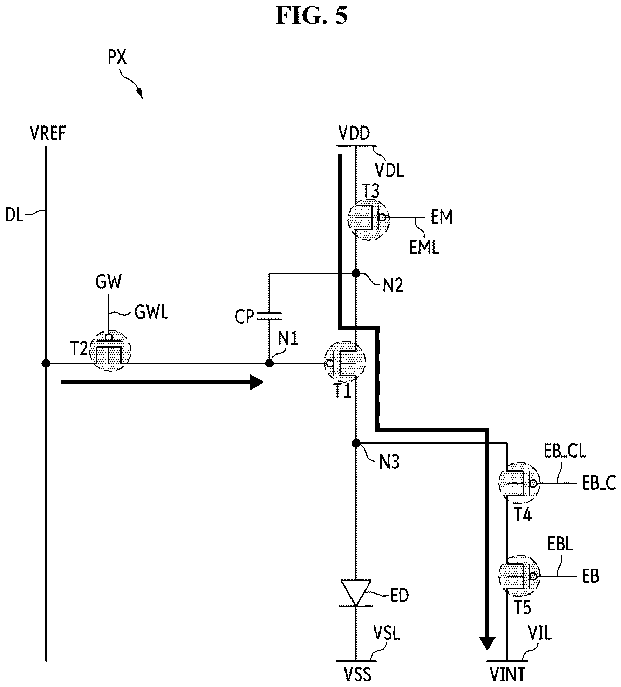

The operation of the display device 10 according to one or more embodiments will be described as follows with reference to FIGS. 4, 5, 6, 7, and 8. The transistors surrounded by a dotted circle in FIGS. 5 to 8 are turned-on transistors, and transistors except the transistors surrounded by the dotted circle may be turned-off transistors. In addition, the arrows in FIGS. 5 to 8 indicate a flow of current.

First, an operation of the display device 10 in a first period P1 will be described as follows with reference to FIGS. 4 and 5.

FIG. 5 is a diagram for describing an operation of the display device 10 of FIG. 3 in a first period P1 of FIG. 4. The first period P1 may be, for example, an initialization period.

As illustrated in FIG. 4, in the first period P1, the initialization gate signal EB, the write gate signal GW, and the emission control signal EM may each have active voltages EBa, GWa, and EMa. In addition, in the first period P1, a reference voltage VREF may be applied to the data line DL. The reference voltage VREF may be, for example, greater than the initialization voltage VINT and less than the driving voltage VDD.

The initialization gate signal EB of the active voltage EBa may be applied to the gate electrode of the fifth transistor T5 through the initialization gate line EBL. Accordingly, the fifth transistor T5 may be turned on.

The write gate signal GW of the active voltage GWa may be applied to the gate electrode of the second transistor T2 through the write gate line GWL. Accordingly, the second transistor T2 may be turned on.

The emission control signal EM of the active voltage EMa may be applied to the gate electrode of the third transistor T3 through the emission control line EML. Accordingly, the third transistor T3 may be turned on.

The cascode voltage EB_C, which is a direct current voltage, may be applied to the gate electrode of the fourth transistor T4 through the cascode line EB_CL. Accordingly, the fourth transistor T4 may be turned on. In this case, because the cascode voltage EB_C is greater than the active voltage GWa of the gate signal (e.g., the write gate signal GW) applied to a transistor (e.g., the second transistor T2) of the same type (e.g., p-type) as the fourth transistor T4, the turned-on fourth transistor T4 may be turned on to a degree that is less than another turned-on transistor (e.g., the second transistor T2). Accordingly, resistance of the turned-on fourth transistor T4 may be greater than resistance of another turned-on transistor (e.g., the fifth transistor T5).

As described above, as the second transistor T2 is turned on, the reference voltage VREF from the data line DL may be applied to the gate electrode (e.g., the first node N1) of the first transistor T1 through the turned-on second transistor T2. In this case, the reference voltage VREF may be maintained at the first node N1 by the capacitor CP. Accordingly, the voltage of the gate electrode (e.g., the gate electrode of the first transistor T1) connected to the first node N1 may be initialized to the reference voltage VREF, and the first transistor T1 may be turned on.

As described above, as the third transistor T3, the first transistor T1, the fourth transistor T4, and the fifth transistor T5 are each turned on, the source electrode of the first transistor T1 (e.g., the second node N2), the drain electrode of the first transistor T1, and the first electrode of the light-emitting element ED (e.g., the third node N3) may be initialized to the initialization voltage VINT, respectively, through the third transistor T3, the first transistor T1, the fourth transistor T4, and the fifth transistor T5 that are turned on.

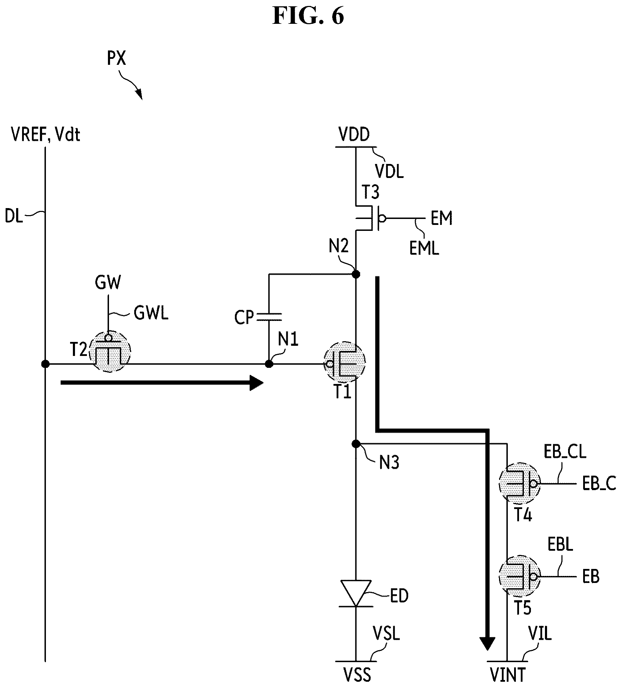

Next, an operation of the display device 10 in a second period P2 will be described as follows with reference to FIGS. 4 and 6.

FIG. 6 is a diagram for describing an operation of the display device 10 of FIG. 3 in a second period P2 of FIG. 4. The second period P2 may be, for example, a threshold voltage detection period and a data writing period of the first transistor T1.

As illustrated in FIG. 4, in the second period P2, the initialization gate signal EB and the write gate signal GW may each have active voltages EBa and GWa. On the other hand, in the second period P2, the emission control signal EM may have a non-active voltage EMb. In addition, in the second period P2, a reference voltage VREF and a data voltage Vdt may be applied to the data line DL. For example, because the second period P2 may include a first sub-period SP1 and a second sub-period SP2 that are consecutive, the reference voltage VREF may be applied to the data line DL in the first sub-period SP1, and the data voltage Vdt corresponding to the pixel PX may be applied to the data line DL in the second sub-period SP2.

The initialization gate signal EB of the active voltage EBa may be applied to the gate electrode of the fifth transistor T5 through the initialization gate line EBL. Accordingly, the fifth transistor T5 may be turned on.

The write gate signal GW of the active voltage GWa may be applied to the gate electrode of the second transistor T2 through the write gate line GWL. Accordingly, the second transistor T2 may be turned on.

The fourth transistor T4 may remain turned on by the cascode voltage EB_C, which is the direct current voltage.

The emission control signal EM of the non-active voltage EMb may be applied to the gate electrode of the third transistor T3 through the emission control line EML. Accordingly, the third transistor T3 may be turned off.

As described above, as the second transistor T2 remains turned on, the reference voltage VREF may be applied and maintained to the first node N1, and the first transistor T1 may be turned on by the reference voltage VREF. Then, a current may flow through the turned-on first transistor T1. For example, charges of the source electrode of the first transistor T1 (e.g., the second node N2) may flow to the initialization voltage line VIL through the turned-on first transistor T1, the turned-on fourth transistor T4, and the turned-on fifth transistor T5. Accordingly, the voltage of the second node N2 may gradually decrease. The first transistor T1 may be turned off at the moment when the voltage of the second node N2 gradually decreases and a voltage difference (e.g., a gate-source voltage of the first transistor T1) between the voltage of the first node N1 and the voltage of the second node N2 reaches the threshold voltage of the first transistor T1, and in this case, the threshold voltage of the first transistor T1 may be stored by the capacitor CP. In other words, the threshold voltage of the first transistor T1 may be detected at the moment when the first transistor T1 is turned off. Therefore, the threshold voltage of the first transistor T1 may be detected and stored in the capacitor CP in the first sub-period SP1 of the second period P2 in which the reference voltage VREF is applied to the data line DL.

Thereafter, the data voltage Vdt may be applied to the data line DL in the second sub-period SP2 of the second period P2, and the data voltage Vdt of the data line DL may be applied to the first node N1 through the turned-on second transistor T2. In this case, by means of the capacitor CP, the voltage of the second node N2 may be maintained at a voltage that is the sum of the data voltage Vdt and the threshold voltage of the first transistor T1. For example, when the threshold voltage of the first transistor T1 is defined as "Vth", the voltage of the second node N2 may have a value corresponding to "Vdt+|Vth|". In other words, the data voltage Vdt and the threshold voltage of the first transistor T1 may be reflected to the second node N2.

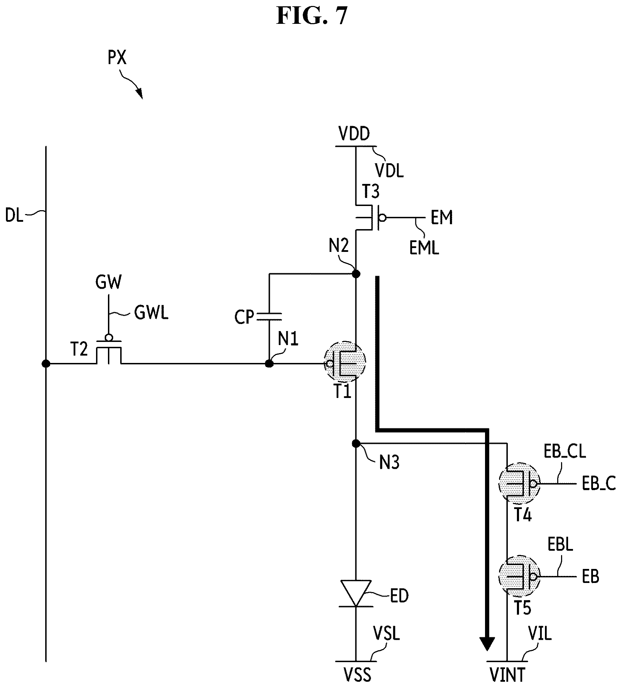

Next, an operation of the display device 10 in a third period P3 will be described as follows with reference to FIGS. 4 and 7. The third period P3 may be anode holding period.

FIG. 7 is a diagram for describing an operation of the display device 10 of FIG. 3 in a third period P3 of FIG. 4.

As illustrated in FIG. 4, in the third period P3, the initialization gate signal EB may have an active voltage EBa. On the other hand, in the third period P3, the emission control signal EM and the write gate signal GW may each have non-active voltages EMb and GWb.

The initialization gate signal EB of the active voltage EBa may be applied to the gate electrode of the fifth transistor T5 through the initialization gate line EBL. Accordingly, the fifth transistor T5 may be turned on.

The fourth transistor T4 may remain turned on by the cascode voltage EB_C, which is the direct current voltage.

The emission control signal EM of the non-active voltage EMb may be applied to the gate electrode of the third transistor T3 through the emission control line EML. Accordingly, the third transistor T3 may be turned off.

The write gate signal GW of the non-active voltage GWb may be applied to the gate electrode of the second transistor T2 through the write gate line GWL. Accordingly, the second transistor T2 may be turned off.

After the threshold voltage of the first transistor T1 is detected, the first transistor T1 may remain turned on.

As described above, as the fourth transistor T4 and the fifth transistor T5 are turned on, respectively, the source electrode of the first transistor T1 (e.g., the second node N2) and the first electrode of the light-emitting element ED (e.g., the third node N3) may be initialized to the initialization voltage VINT through the fourth transistor T4 and the fifth transistor T5 that are turned on.

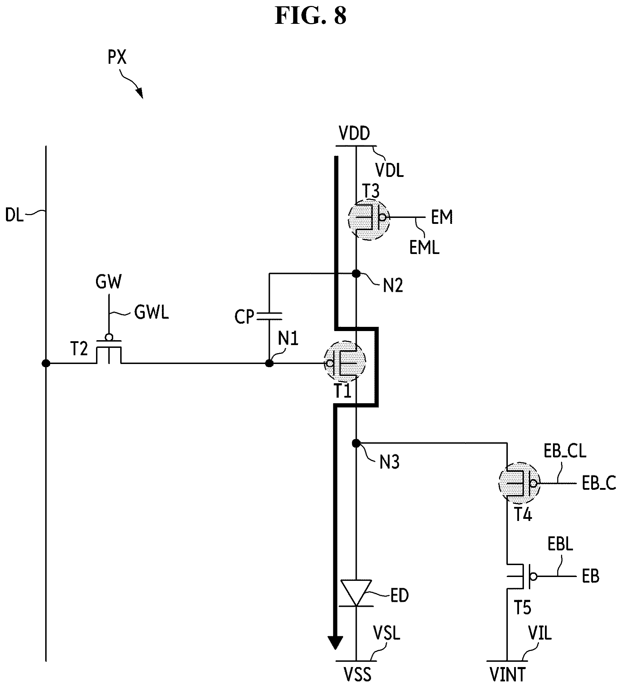

Thereafter, an operation of the display device 10 in a fourth period P4 will be described as follows with reference to FIGS. 4 and 8. The fourth period P4 may be, for example, a light-emitting period.

FIG. 8 is a diagram for describing an operation of the display device 10 of FIG. 3 in a fourth period P4 of FIG. 4.

As illustrated in FIG. 4, in the fourth period P4, the emission control signal EM may have an active voltage EMa. On the other hand, in the fourth period P4, the initialization gate signal EB and the write gate signal GW may each have non-active voltages EBb and GWb.

The emission control signal EM of the active voltage EMa may be applied to the gate electrode of the third transistor T3 through the emission control line EML. Accordingly, the third transistor T3 may be turned on.

The fourth transistor T4 may remain turned on by the cascode voltage EB_C, which is the direct current voltage.

The initialization gate signal EB of the non-active voltage EBb may be applied to the gate electrode of the fifth transistor T5 through the initialization gate line EBL. Accordingly, the fifth transistor T5 may be turned off.

The write gate signal GW of the non-active voltage GWb may be applied to the gate electrode of the second transistor T2 through the write gate line GWL. Accordingly, the second transistor T2 may be turned off.

As the driving voltage VDD is applied to the source electrode of the first transistor T1 (e.g., the second node N2) by the turned-on third transistor T3, the voltage of the source electrode of the first transistor T1 may increase. Accordingly, the first transistor T1 may be turned on.

As described above, as the third transistor T3 and the first transistor T1 are each turned on, the driving current may be supplied to the light-emitting element ED through the third transistor T3 and the first transistor T1 that are turned on. Because the fourth transistor T4 is turned on, but the fifth transistor T5 between the fourth transistor T4 and the initialization voltage line VIL is turned off, the driving current described above may flow toward the light-emitting element ED rather than toward the initialization voltage line VIL. Therefore, the light-emitting element ED may emit light depending on the driving current.

According to one or more embodiments, the fourth transistor T4 may serve as a resistor connected between the light-emitting element ED and the fifth transistor T5. Accordingly, the voltage of the first electrode of the light-emitting element ED (e.g., the third node N3) may be divided by a resistance component of the fourth transistor T4 and a resistance component of the fifth transistor T5. Therefore, a withstand voltage across the fifth transistor T5, which is the initialization transistor, may be reduced. In other words, because the voltage of the third node N3 is distributed and applied to the fourth transistor T4 and the fifth transistor T5, the withstand voltage of the fifth transistor T5, which is the initialization transistor, may be reduced. Here, the withstand voltage of the fifth transistor T5 may be, for example, a differential voltage between the gate electrode of the fifth transistor T5 and the source electrode of the fifth transistor T5 (e.g., the gate-source voltage of the fifth transistor T5).

When the source electrode of the fifth transistor T5 is directly connected to the third node N3 without the fourth transistor T4, the withstand voltage of the fifth transistor T5 (e.g., the gate-source voltage of the fifth transistor T5) may be about 9.3 V. On the other hand, when the fourth transistor T4 is connected between the third node N3 and the fifth transistor T5, the withstand voltage of the fifth transistor T5 (e.g., the gate-source voltage of the fifth transistor T5) may be about 5.3 V. However, the invention is not limited to this.

In this way, because the voltage between the first electrode of the light-emitting element ED and the initialization voltage line VIL may be divided by the fourth transistor T4, a low-voltage element (e.g., a transistor capable of operating in a low-voltage range) may be used in the pixel PX of the display device 10 according to one or more embodiments. For example, at least one of the fourth transistor T4 or the fifth transistor T5 may be a low-voltage range transistor capable of operating in the low-voltage range. Therefore, power consumption of the display device 10 may be improved.

The display device 10 may be applied to various electronic devices. An electronic device according to one or more embodiments may include the display device 10 described above, and may further include a module or device having additional functions in addition to the display device 10.

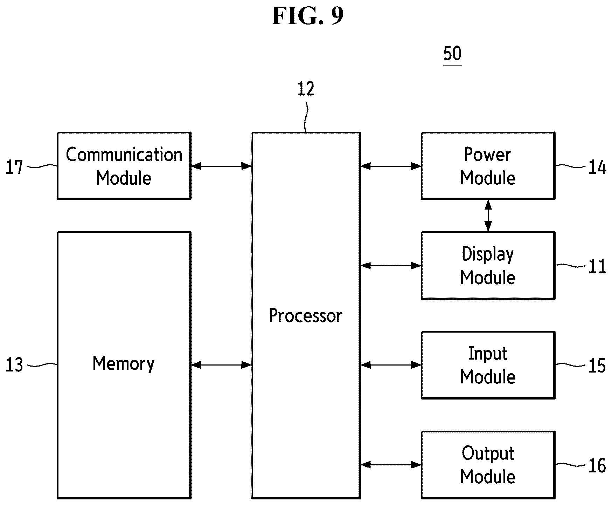

FIG. 9 is a block diagram of an electronic device according to one or more embodiments. Referring to FIG. 9, an electronic device 50 according to one or more embodiments may include a display module 11, a processor 12, a memory 13, and a power module 14. The electronic device 50 may further include an input module 15, a non-image output module 16, and/or a communication module 17.

The electronic device 50 may output various information in the form of an image through the display module 11. When the processor 12 executes an application stored in the memory 13, image information provided by the application may be provided to the user through the display module 11. The power module 14 may include a power supply module, such as a power adapter or a battery device, and a power conversion module that converts power supplied by the power supply module to generate power required for an operation of the electronic device 50. The input module 15 may provide input information to the processor 12 and/or the display module 11. The non-image output module 16 may serve to receive information other than the image received from the processor 12, such as sound, haptics, and light emission, and may provide the information to the user. The communication module 17 is a module responsible for transmitting and receiving information between the electronic device 50 and an external device, and may include a receiver and a transmitter.

At least one of the components of the electronic device 50 described above may be included in the display device according to the above-described embodiments. In addition, some of the individual modules functionally included within one module may be included within the display device, while others may be provided separately from the display device. For example, the display device includes the display module 11, and the processor 12, the memory 13, and the power module 14 may be provided in the form of other devices within the electronic device 50 other than the display device.

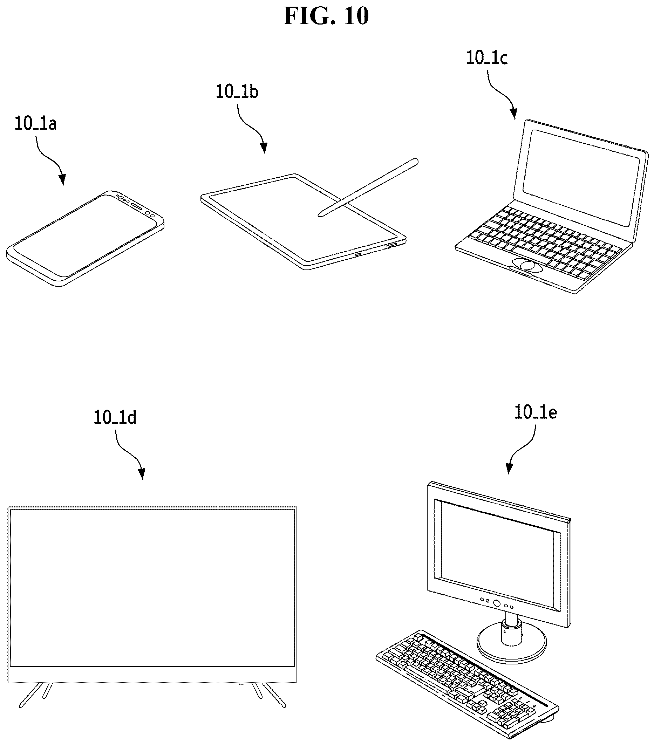

FIGS. 10, 11, and 12 are schematic diagrams of electronic devices according to various embodiments. FIGS. 10 to 12 illustrate examples of various electronic devices to which the display device 10 according to the embodiments is applied.

FIG. 10 illustrates examples of the electronic devices, including a smartphone 10_1a, a tablet PC 10_1b, a laptop 10_1c, a TV 10_1d, and a desk monitor 10_1e.

The smartphone 10_1a may include an input module, such as a touch sensor and a communication module in addition to the display module 11. The smartphone 10_1a may process information received through the communication module or other input modules and display the information through the display module of the display device.

The tablet PC 10_1b, the laptop 10_1c, the TV 10_1d, and the desk monitor 10_1e also include a display module and an input module similarly to the smartphone 10_1a, and in some cases, may further include a communication module.

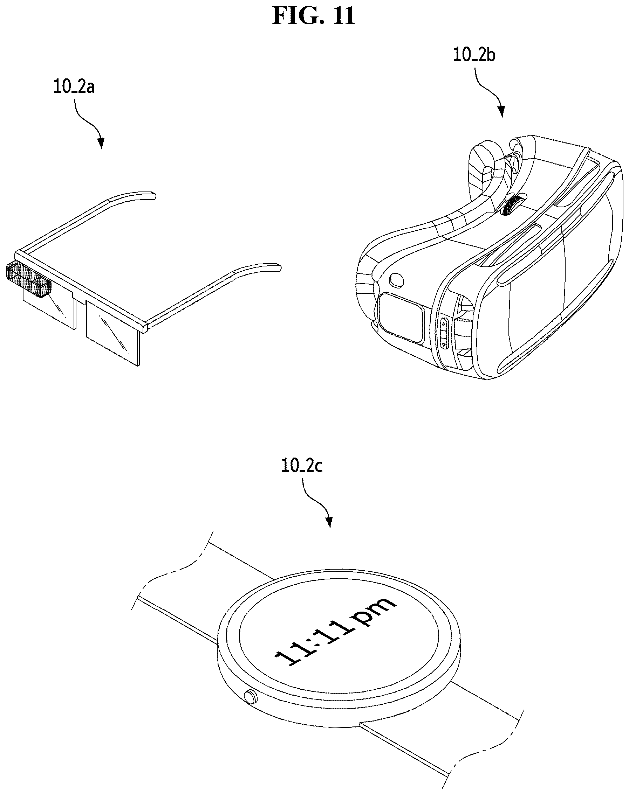

FIG. 11 illustrates a case in which an electronic device including a display module is applied to a wearable electronic device. The wearable electronic device may be a smart glasses 10_2a, a head-mounted display 10_2b, a smart watch 10_2c, etc.

The smart glasses 10_2a and the head-mounted display 10_2b may include a display module that emits a display image and a reflector that reflects the emitted display image and provides the reflected display image to the user's eyes, and may provide the user with a virtual reality or augmented reality screen through the display module and the reflector.

The smart watch 10_2c includes a biometric sensor as an input device and may provide the biometric information recognized by the biometric sensor to the user through the display module.

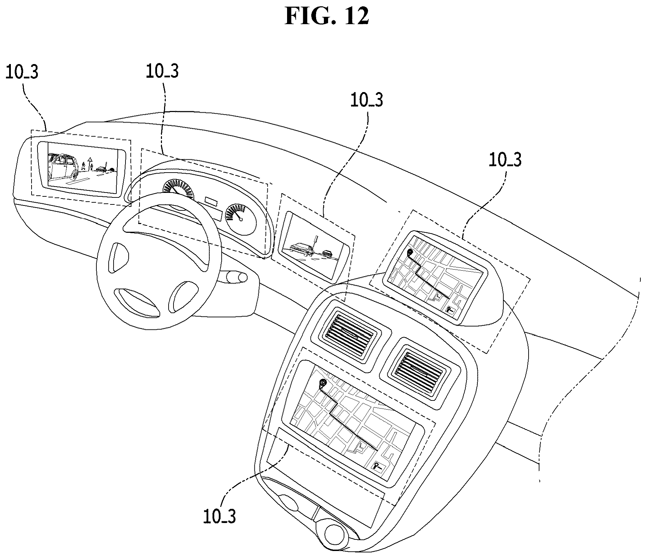

FIG. 12 illustrates an example in which an electronic device including a display module is applied to a vehicle. For example, an electronic device 10_3 may be applied to a dashboard, center fascia, etc. of an automobile, or may be applied to a Center Information Display (CID) located on the dashboard of the automobile or a room mirror display replacing a side mirror.

In concluding the detailed description, those skilled in the art will appreciate that many variations and modifications can be made to the embodiments without substantially departing from the aspects of the present disclosure. Therefore, the disclosed embodiments are used in a generic and descriptive sense only and not for purposes of limitation.

## Claims

1. A display device (10) comprising:
a pixel (PX) comprising:
a light-emitting element (ED) connected between a driving voltage line (VDL) and a common voltage line (VSL);
a first transistor (T1) connected between the driving voltage line (VDL) and the light-emitting element (ED), and comprising a gate electrode connected to a first node (N1) and a source electrode connected to a second node (N2);
a second transistor (T2) comprising a gate electrode connected to a gate line (GWL), a source electrode connected to a data line (DL), and a drain electrode connected to the first node (N1); and
a fourth transistor (T4) and a fifth transistor (T5) connected in series between the light-emitting element (ED) and an initialization voltage line (VIL), the fourth transistor (T4) being connected between a first electrode of the light-emitting element (ED) and the fifth transistor (T5) and comprising a gate electrode configured to receive a cascode voltage (EB_C) having a value between an active voltage (EBa) of an initialization gate signal (EB) configured to be received by a gate electrode of the fifth transistor (T5) and a non-active voltage (EBb) of the initialization gate signal (EB).

2. The display device (10) of claim 1, wherein the fourth transistor (T4) and the fifth transistor (T5) are a same type of transistor, and
wherein the cascode voltage (EB_C) is greater than the active voltage (EBa) of the initialization gate signal (EB) and is less than the non-active voltage (EBb) of the initialization gate signal (EB).

3. The display device (10) of claim 2, wherein the fourth transistor (T4) and the fifth transistor (T5) comprise p-type transistors.

4. The display device (10) of any preceding claim, wherein the gate electrode of the fourth transistor (T4) is connected to a cascode line (EB_CL) configured to transmit the cascode voltage (EB_C).

5. The display device (10) of any preceding claim, wherein a source electrode of the fourth transistor (T4) is connected to the first electrode of the light-emitting element (ED) and to a drain electrode of the first transistor (T1),
wherein a drain electrode of the fourth transistor (T4) is connected to a source electrode of the fifth transistor (T5), and
wherein a second electrode of the light-emitting element (ED) is connected to the common voltage line (VSL).

6. The display device (10) of any preceding claim, wherein the pixel (PX) further comprises a capacitor (CP) connected between the first node (N1) and the second node (N2).

7. The display device (10) of any preceding claim, wherein the pixel (PX) further comprises a third transistor (T3) connected between the driving voltage line (VDL) and the second node (N2).

8. The display device (10) of claim 7, wherein, in a first period (P1):
the gate electrode of the fifth transistor (T5) is configured to receive the initialization gate signal (EB) having the active voltage (EBa);
the gate electrode of the second transistor (T2) is configured to receive a write gate signal (GW) having an active voltage (GWa);
a gate electrode of the third transistor (T3) is configured to receive an emission control signal (EM) having an active voltage (EMa); and
the data line (DL) is configured to receive a reference voltage (VREF).

9. The display device (10) of claim 8, wherein, in a second period (P2) after the first period (P1):
the initialization gate signal (EB) is configured to have the active voltage (EBa);
the write gate signal (GW) is configured to have the active voltage (GWa);
the emission control signal (EM) is configured to have a non-active voltage (EMb); and
the data line (DL) is configured to receive the reference voltage (VREF) in a first sub-period (SP1) of the second period (P2), and is configured to receive a data voltage (Vdt) corresponding to the pixel (PX) in a second sub-period (SP2) of the second period (P2).

10. The display device (10) of claim 9, wherein, in a third period (P3) after the second period (P2):
the initialization gate signal (EB) is configured to have the active voltage (EBa);
the emission control signal (EM) is configured to have the non-active voltage (EMb); and
the write gate signal (GW) is configured to have a non-active voltage (GWb).

11. The display device (10) of claim 10, wherein, in a fourth period (P4) after the third period (P3):
the emission control signal (EM) is configured to have the active voltage (EMa);
the initialization gate signal (EB) is configured to have the non-active voltage (EBb); and
the write gate signal (GW) is configured to have the non-active voltage (GWb).

12. The display device (10) of any of claims 7-11, wherein the first transistor (T1), the second transistor (T2), the third transistor (T3), the fourth transistor (T4), and the fifth transistor (T5) comprise metal-oxide-semiconductor field-effect transistors (MOSFET).

13. An electronic device (50) comprising a display device (10) according to any preceding claim.

14. The electronic device of claim 13, wherein the electronic device comprises a smartphone, a tablet, a laptop, a TV, a desk monitor, a smart glasses, a smart watch, a head-mounted display, or a vehicle.
